# EUROPÄISCHE PATENTANMELDUNG

(11) **EP 4 667 948 A1**
(43) Veröffentlichungstag der Anmeldung: **24.12.2025**
(21) Anmeldenummer: 24182949.8
(22) Anmeldetag: 18.06.2024
(51) Int. Cl.: G01R 19/25, G05B 9/02

(54) **ANLAGE MIT EINEM NETZWÄCHTER UND DIESER NETZWÄCHTER FÜR EIN LEITUNGSNETZ**

(71) Anmelder: DIN-Dietmar Nocker Facilitymanagement GmbH, 4030 Linz (AT)
(72) Erfinder:
(74) Vertreter: Jell, Friedrich

(57) **Zusammenfassung**

Es wird eine Anlage (1) mit einem Netzwächter (2) sowie dieser Netzwächter (2) für ein Leitungsnetz (3) gezeigt. Um den Installationsaufwand des Netzwächter (2) zu vereinfachen und dessen Funktion zu erweitern, wird vorgeschlagen, dass der Netzwächter (2) eine mit der Überwachungseinrichtung (6) verbundene Datenschnittstelle (10) für einen Datenbus (11) zur drahtlosen und/oder drahtgebundenen Datenverbindung mit einer Überwachungszentrale (12), insbesondere Notbeleuchtungszentrale, aufweist, wobei die Überwachungseinrichtung zur Kommunikation dieses Phasenausfalls und/oder Phasenfehlers über die Datenschnittstelle (10) ausgebildet ist, dass der Netzwächter (2) zumindest eine elektrische Quelle (13) zur Beaufschlagung des Anschlusspaars (8) mit einem Linienstrom (IL) oder einer Linienspannung (UL) aufweist, und dass die Überwachungseinrichtung (6) zur Überwachung der elektrischen Meldeleitung (9) über das Anschlusspaar (8) auf Unterbrechung und/oder Veränderung des Linienstroms (IL) oder der Linienspannung (UL) sowie zur Kommunikation dieser Unterbrechung und/oder Veränderung über die Datenschnittstelle (10) ausgebildet ist.

## Beschreibung

Die Erfindung betrifft eine Anlage mit einem Netzwächter und diesen Netzwächter für ein Leitungsnetz.

Um von mehreren Netzwächtern in einem Leitungsnetz detektierte Fehler bei der Netzversorgung melden zu können, ist es aus dem Stand der Technik bekannt, die Netzwächter über eine als Eindrahtleitung ausgebildete Meldeleitung zu verbinden. Hierzu weisen die Netzwächter je ein Anschlusspaar für die elektrische Meldeleitung auf, die von einer zentralen Steuereinrichtung überwacht wird. Wird ein Fehler über die Meldeleitung erkannt, kann die zentrale Steuereinheit eine Aktion auslösen. Nachteilig findet eine Überwachung der Steuereinheit selbst nicht statt, was ein Sicherheitsrisiko darstellt und den Einsatz einer derartigen Anlage bei sicherheitsrelevanten Anwendungen ausschließt. Zwar schlägt die EP2520988A1 eine Überwachungseinrichtung vor, diese ist aber den einzelnen Netzwächtern zu deren Testung zugeordnet. Zudem ist diese Anlage vergleichsweise komplex aufgebaut und bedarf insbesondere bei örtlich verteilt angeordneten Netzwächtern einen erheblichen Verdrahtungsaufwand.

Die Erfindung hat sich daher die Aufgabe gestellt, einen Netzwächter zu schaffen, mit der zuverlässig eine Anlage beispielsweise auch in sicherheitstechnisch relevanten Bereichen aufgebaut werden kann. Zudem soll der Netzwächter einen verminderten Installationsaufwand aufweisen und vielfältig einsetzbar sein.

Die Erfindung löst die gestellte Aufgabe durch die Merkmale des Anspruchs 1.

Indem der Netzwächter eine mit der Überwachungseinrichtung verbundene Datenschnittstelle für einen Datenbus zur drahtlosen und/oder drahtgebundenen Datenverbindung mit einer Überwachungszentrale, insbesondere Notbeleuchtungszentrale, aufweist, kann der Netzwächter in an sich bekannterweise zur Einbindung in einen Datenbus weiterentwickelt werden.

Dies, indem die Überwachungseinrichtung zur Kommunikation dieses Phasenausfalls und/oder Phasenfehlers über die Datenschnittstelle ausgebildet ist. Ein Ausfall und/oder Fehler in der Netzversorgung kann dadurch über den Datenbus an eine Überwachungseinrichtung übermittelt werden. Dieser Datenbus kann beispielsweise von einer Eindrahtleitung oder Mehrdrahtleitung gebildet werden.

Um einen örtlichen Verdrahtungsaufwand zu minimieren, ist zudem erfindungsgemäß vorgesehen, dass der Netzwächter zumindest eine elektrische Quelle zur Beaufschlagung des Anschlusspaars mit einem Linienstrom oder einer Linienspannung aufweist, und dass die Überwachungseinrichtung zur Überwachung der elektrischen Meldeleitung über das Anschlusspaar auf Unterbrechung und/oder Veränderung des Linienstroms oder der Linienspannung sowie zur Kommunikation dieser Unterbrechung und/oder Veränderung über die Datenschnittstelle ausgebildet ist. Damit kann der Netzwächter auch eine Fehlermeldung zumindest eines anderen Melders und/oder eines Schutzschaltgeräts am Leitungsnetz erkennen und über dessen Datenschnittstelle an die Überwachungszentrale weiterleiten. Der Netzwächter ist daher vielfältiger einsetzbar -denn die Überwachungseinrichtung des erfindungsgemäßen Netzwächters dient daher nicht nur zur Überwachung des Leitungsnetzes, sondern auch zur Übermittlung von anderen Fehlern am Leitungsnetz, wie beispielsweise einer Überlastung. Es kann daher ausreichen, örtlich gesehen diesen einen erfindungsgemäßen Netzwächter in den Datenbus einzubinden, da die anderen an diesem Ort, beispielsweise in demselben Schaltkasten, vorgesehenen Geräte, wie beispielsweise Schutzschaltgeräte, über die Meldeleitung mit überwacht werden. Dies vereinfacht und reduziert die Verdrahtung zwischen Zentrale und Schaltkasten erheblich, was die Montage und Wartung der Anlage weiter erleichtern kann. Mit dem erfindungsgemäße Netzwächter kann daher mit vermindertem Installationsaufwand zuverlässig eine Anlage auch in einem sicherheitstechnisch relevanten Bereich aufgebaut werden.

Vorzugsweise ist das Anschlusspaar zum Anschluss von zumindest einem Schutzschaltgerät, insbesondere Leitungsschutzschalter und/oder Fehlerstromschutzschalter, am Leitungsnetz über die Meldeleitung ausgebildet.

Die Konstruktion des Netzwächters kann beispielsweise vereinfacht werden, wenn die elektrische Quelle eine Konstant-Stromquelle oder Konstant-Spannungsquelle zur Beaufschlagung des Anschlusspaars mit einem Linienstrom oder einer Linienspannung aufweist. Zudem können Veränderungen an einem durch eine Konstant-Stromquelle eingeprägten Linienstrom oder Konstant-Spannungsquelle eingeprägten Linienspannung zuverlässig von der Überwachungseinrichtung erkannt werden. Dies erhöht die Standfestigkeit des Netzwächters weiter.

Die Überwachung des Leitungsnetzes kann weiter verbessert werden, wenn die Überwachungseinrichtung eine mit dem Phasenanschluss verbundene Schwellenschaltung aufweist, die eine am Phasenanschluss anliegende Spannung mittels einer beispielsweise vorgegebenen Mindestspannung als Schwelle in ein Signal konvertiert. Dieses Signal kann beispielsweise ein digitales Signal, beispielsweise ein Binärsignal, sein.

Diese anliegende Spannung kann beispielsweise eine Phasenspannung sein, die zwischen der Phasenleitung und einem Nullleiter des Leitungsnetzes anliegt. Es ist aber auch vorstellbar, dass die Spannung eine Netzspannung ist, die zwischen den Phasenleitungen anliegt.

Vorzugsweise weist die Schwellenschaltung einen mit dem Phasenanschluss verbundenen Spannungsteiler auf, der das Verhältnis der Spannungsteilung bestimmende Teilwiderstände aufweist, und eine an zumindest einen Abgriff, insbesondere an zwei Abgriffen, zwischen den Teilwiderständen des Spannungsteilers angeschossene, insbesondere als Optokoppler ausgebildete, Schaltstufe zur Erzeugung des Signals auf. Beispielsweise kann dies bei konstruktiver Einfachheit eine zuverlässige Überwachung der Phasenleitung des Leitungsnetzes ermöglichen.

Der Netzwächter kann um einen Selbsttest erweitert werden, indem der Netzwächter eine Testschaltung aufweist, die bei einer Testung des Netzwächters die vorgegebene Schwelle erhöht. Diese Erhöhung kann beispielsweise über die Normspannung der Phasenleitung des Leitungsnetzes hinaus erfolgen. Zudem kann damit diese Testschaltung vergleichsweise konstruktiv einfach ausgebildet werden, was den Herstellungsaufwand des Netzwächters weiter verringern kann.

Diese Erhöhung kann standfest ermöglicht werden, wenn die Testschaltung bei Testung des Netzwächters das Teilungsverhältnis des Spannungsteilers durch Zu- und/oder Wegschalten von zumindest einem Teilwiderstand verändert und damit die vorgegebene Schwelle erhöht.

Vorzugsweise kann die Überwachungseinrichtung das erzeugte Signal zur Erkennung eines Phasenausfalls und/oder -fehlers überwachen.

Vorstellbar ist beispielsweise weiter, dass der Netzwächter zumindest einen Nullleiteranschluss, insbesondere eine Anschlussklemme, für zumindest einen Nullleiter des Leitungsnetzes aufweist, wobei die Überwachungseinrichtung zur Überwachung der Phasenleitung am Phasenanschluss gegen Nullleiter am Nulleiteranschluss auf Phasenausfall und/oder Phasenfehler ausgebildet ist. Damit kann insbesondere die Phasenspannung der Phasenleitung überwacht werden.

Die Einbindung des Netzwächters in einen Datenbus kann sich weiter erleichtern, wenn beispielsweise die Datenschnittstelle einen Schalter und zumindest einen Abschlusswiderstand aufweist, der über den Schalter an den an die Datenschnittstelle angeschlossenen Datenbus zu- und wegschaltbar ist.

Der erfindungsgemäße Netzwächter eignet sich insbesondere bei einer Anlage mit zumindest einem Melder und/oder zumindest einem Schutzschaltgerät für ein Leitungsnetz, und mit zumindest einer Meldeleitung, wobei in die Meldeleitung vom Anschlusspaar des Netzwächters ausgehend der Melder oder das Schutzschaltgerät eingeschliffen ist. Damit kann beispielsweise ein Stockwerk eines Gebäudes vollständig überwacht und auch auf Funktion getestet werden.

Dies insbesondere, wenn in die Meldeleitung vom Anschlusspaar des Netzwächters ausgehend mehrere Melder und/oder Schutzschaltgeräte in Reihe eingeschliffen sind.

Die Erfindung hat sich zudem die Aufgabe gestellt, ein Verfahren zur Überwachung zumindest einer Phasenleitung eines Leitungsnetzes zuverlässiger auszubilden. Zudem soll das Verfahren einfach handzuhaben sein.

Die Erfindung löst die gestellte Aufgabe durch die Merkmale des Anspruchs 11.

Indem das erfindungsgemäße Verfahren den erfindungsgemäßen Netzwächter oder die erfindungsgemäße Anlage verwendet, erleichtert sich dessen Handhabung sowie erhöht sich dessen Zuverlässigkeit erheblich.

Diese Überwachung kann weiter verbessert, wenn der Netzwächter auf Funktion zur Detektion eines Phasenausfalls und/oder -fehlers getestet wird, indem die Testschaltung die Schwelle für die Schaltstufe der Schwellenschaltung erhöht.

In den Figuren ist beispielsweise der Erfindungsgegenstand anhand eines Ausführungsbeispiels näher dargestellt. Es zeigen
- Fig. 1: eine schematische Ansicht auf eine Anlage mit einem Netzwächter,
- Fig. 2: eine schematische Ansicht auf den nach Fig.1 dargestellten Netzwächter,
- Fig. 3: eine schematische Ansicht zu einem Teil einer Schwellenschaltung des nach Fig. 1 dargestellten Netzwächters und
- Fig. 4: eine Darstellung zu einem von der Schwellenschaltung nach Fig. 3 erzeugten Binärsignal.

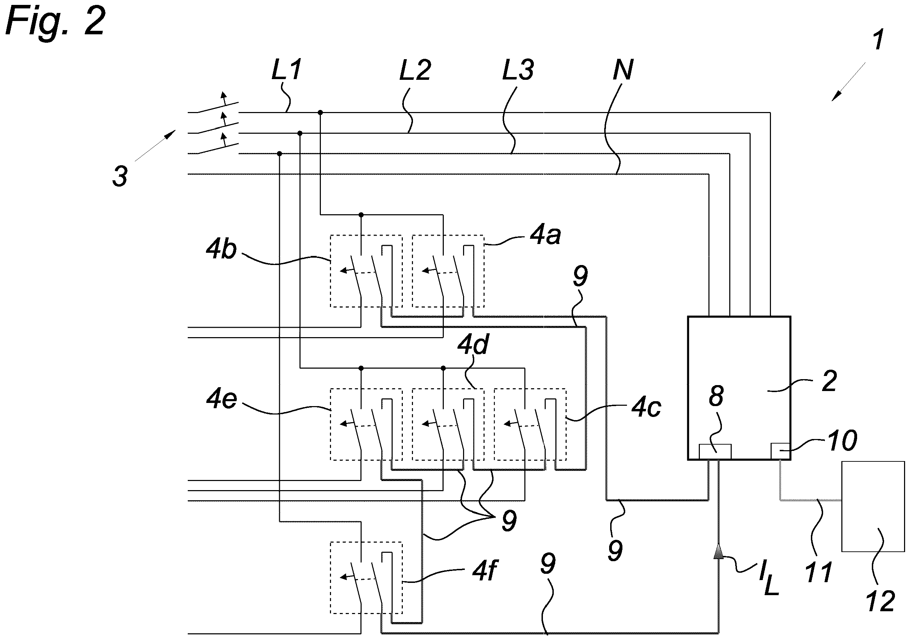

Nach Fig. 2 ist eine Anlage 1 dargestellt, die einen Netzwächter 2, ein Leitungsnetz 3 mit drei Phasenleitungen L1, L2, L3 und mit einem Nullleiter N, und mehrere Schutzschaltgeräte 4a bis 4f, nämlich Leitungsschutzschalter, im Leitungsnetz 3 aufweist. Beim dargestellten Leitungsnetz 3 handelt es sich um ein Niederspannungsnetz, nämlich um ein Drehstromnetz.

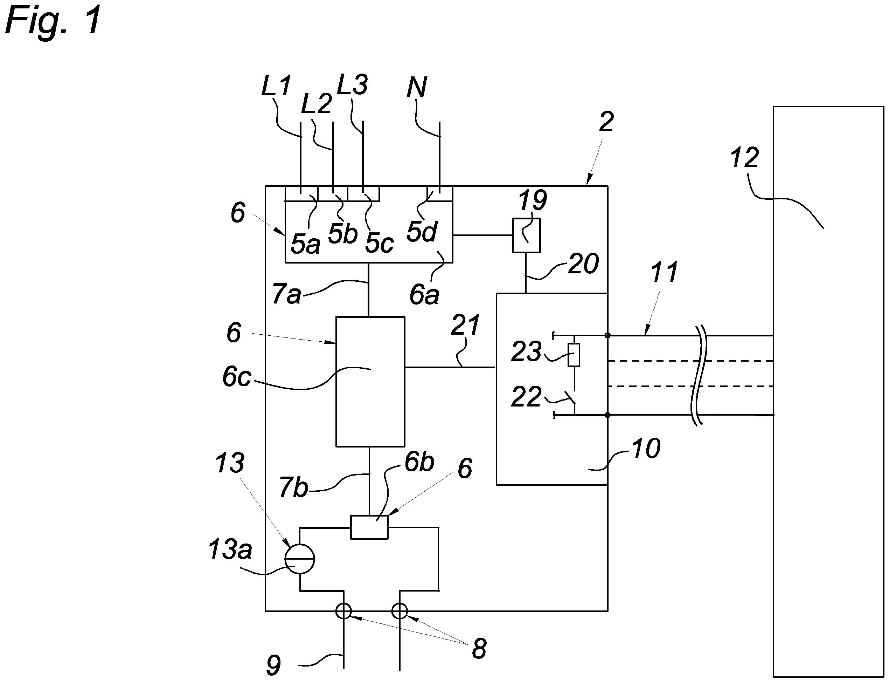

Der im Detail in Fig. 1 dargestellte Netzwächter 2 weist zum Anschluss der Phasenleitungen L1, L2, L3 je einen als Anschlussklemme ausgebildeten Phasenanschluss 5a, 5b, 5c und für den Nullleiters N einen als Anschlussklemme ausgebildeten Nullleiteranschluss 5d auf.

Eine Überwachungseinrichtung 6 des Netzwächters 2 ist mit den Phasenanschlüssen 5a bis 5c und mit dem Nullleiteranschluss 5d verbunden und überwacht damit alle Phasenleitungen L1, L2, L3 der Phasenanschlüsse 5a bis 5c. Hierzu überwacht die Überwachungseinrichtung 6 jeweils die Amplitude der Phasenspannung der Phasenleitungen (L1, L2, L3) am jeweiligen Phasenanschluss 5a bis 5c. Zu diesem Zweck weist die Überwachungseinrichtung 6 eine Schwellenschaltung 6a auf, die mit jedem Phasenanschluss 5a bis 5c elektrisch verbunden ist. Die Schwellenschaltung 6a erzeugt für jeden Phasenanschluss 5a bis 5c ein Signal 15, die über je eine Leitung der ersten und dreidrahtig ausgeführten Messleitung 7a dem Prozessor 6c der Überwachungseinrichtung 6 zugeführt und von diesem Prozessor 6c ausgewertet wird. Damit kann die Überwachungseinrichtung 6 einen Phasenausfall und/oder Phasenfehler am Leitungsnetz 3 erkennen bzw. detektieren. Solche ein Phasenausfall und/oder -fehler kann eine einzelne Phasenleitung (L1, L2, L3) am Phasenanschluss (5a, 5b, 5c) betreffen oder sich bei Betrachtung der Phasenleitungen (L1, L2, L3) zueinander ergeben.

Zudem weist der Netzwächter 2 ein Anschlusspaar 8 für eine elektrische eindrahtige Meldeleitung 9, auch unter Meldeschleife bekannt, auf.

Wird von der Überwachungseinrichtung 6 ein Phasenausfall und/oder -fehler detektiert, dann ist die Überwachungseinrichtung 6 erfindungsgemäß so ausgebildet, diesen Ausfall und/oder Fehler über eine Datenschnittstelle 10 des Netzwächters 2 zu übertragen - und zwar über einen drahtgebundenen Datenbus 11 zu einer als Notbeleuchtungszentrale ausgebildeten Überwachungszentrale 12. Hierzu ist der Prozessor 6c der Überwachungseinrichtung 6 über einen Peripheriebus 21 mit der Datenschnittstelle 10 verbunden.

Zudem weist der erfindungsgemäße Netzwächter 2 eine elektrische Quelle 13 zur Beaufschlagung des Anschlusspaars 8 mit einem Linienstrom I_{L} auf. Hierzu ist der elektrischen Quelle 13 eine Konstantstromquelle 13a zugeordnet. Die Überwachungseinrichtung 6 überwacht über das Anschlusspaar 8 die elektrische Meldeleitung 9. Hierzu ist eine Messeinrichtung 6b vorgesehen, die den Linienstrom I_{L} misst und an den Prozessor 6c über eine zweite Messleitung 7b meldet. Wird beispielsweise eine Unterbrechung und/oder Veränderung des Linienstroms I_{L} von der Überwachungseinrichtung 6 detektiert, dann wird auch diese Störung über die Datenschnittstelle 10 an die Überwachungszentrale 12 gemeldet oder kommuniziert. Damit kann der erfindungsgemäße Netzwächter 2 neben der Überwachung der Phasen L1, L2, L3 des Leitungsnetzes 3 auch im Ausführungsbeispiel die Schutzschaltgeräte 4a bis 4f im Leitungsnetz 3 mit überwachen. Hierzu sind nämlich die Schutzschaltgeräte 4a bis 4f in der Meldeleitung 9 in Reihe eingeschliffen, wie in Fig. 1 zu erkennen. Es ist aber auch vorstellbar, dass in diese Meldeleitung ein Melder, wie beispielsweise ein Melder einer Gefahrenmeldeanlage, Einbruchmeldeanlage etc. angeschlossen ist, was nicht näher dargestellt wurde.

Fällt ein Schutzschaltgerät 4a bis 4f beispielsweise aufgrund Überlastung aus, dann wird die Meldeleitung 9 vom Schutzschaltgerät 4a bis 4f unterbrochen. Diese elektrische Unterbrechung der Meldeleitung 9 detektiert der Netzwächter 2 und teilt diese der Überwachungszentrale 12 über den Datenbus 11 mit.

Im Allgemeinen wird erwähnt, dass die Kommunikation des Netzwächter 2 über die Datenschnittstelle 10 selbstständig vom Netzwächter 2 und/oder auch von der Überwachungszentrale 12 initialisiert sein kann, beispielsweise über eine Statusabfrage an den Netzwächter 2 über den Datenbus 11.

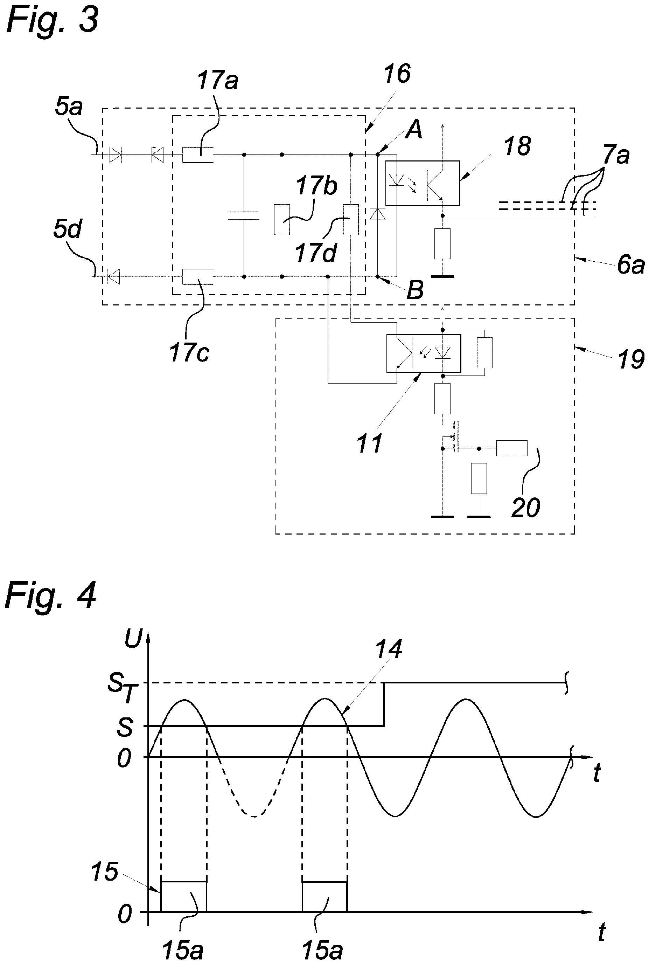

Der nach Fig. 3 für einen Phasenanschluss dargestellte Teil der Schwellenschaltung 6a ist mit dem Phasenanschluss 5a und mit dem Nullleiteranschluss 5d elektrisch verbunden. Die Schwellenschaltung 6a ist ausgebildet, aus der Phasenspannung 14 (Spannung zwischen einer Phasenleitung L1, L2 oder L3 und dem Nullleiter N) ein nach Fig. 4 dargestelltes digitales Signal 15, nämlich Binärsignal, zu erzeugen. Damit konvertiert die Schwellenschaltung 6a die am Phasenanschluss 5a, 5b, 5c anliegende Spannung U, nämlich Phasenspannung, in ein digitales Signal 15, nämlich Binärsignal. Die Überwachungseinrichtung 6 überwacht dieses Signal 15, um damit einen Phasenausfall und/oder -fehler an diesem Phasenanschluss 5a zu erkennen. Jene Teile der Schwellenschaltung 6a sind für die anderen Phasenanschlüsse 5b bis 5c gleich ausgeführt, in Fig. 3 jedoch nicht dargestellt.

Zur Erzeugung des Signals 15 weist die Schwellenschaltung 6a einen mit dem Phasenanschluss 5a verbundenen Spannungsteiler 16 mit Teilwiderständen 17a bis 17d auf, die das Verhältnis der Spannungsteilung bestimmen.

Der Schwellenschaltung 6a gehört zudem eine Schaltstufe 18 zur Erzeugung des Signals 15 zu. Die Schaltstufe 18 wird von einem Optokoppler ausgebildet, der an zwei Abgriffen A, B zwischen den Teilwiderständen 17a, 17b, 17c, 17d des Spannungsteilers 16 angeschossen ist, und zwar an den parallel liegenden Teilwiderständen 17b, 17d, wie in Fig. 3 zu erkennen.

Liegt die Spannung 19 der positiven Halbwelle der Wechselspannung am Phasenanschluss 5a über der Schwelle S des ersten Optokopplers als Schaltstufe 18, dann bildet sich ein Impuls 15a am Signal 15 aus. Damit eröffnet sich die Möglichkeit über Länge und/oder Abstand der Impulse 15a des Signals 15 einen Phasenausfall und/oder -fehler zu erkennen.

Dies auch zuverlässig, da der Netzwächter 2 eine Selbsttestung durchführen kann. Der Netzwächter 2 weist nämlich eine Testschaltung 19 auf, die bei Testung des Netzwächters 2 die vorgegebene Schwelle S über die Normspannung der Phasenleitung L1, L2, L3 des Leitungsnetzes 3 hinaus erhöht, wie in Fig. 4 zu erkennen.

Dies, indem die Testschaltung 19 bei Testung des Netzwächters 2 das Teilungsverhältnis des Spannungsteilers 16 durch Zuschalten des vierten Teilwiderstands 17d verändert. Da damit der vierte Teilwiderstand 17d zum zweiten Teilwiderstand 17b parallel geschaltet ist, sinkt der Gesamtwiderstand, was die am ersten Optokoppler als Schaltstufe 18 anliegende Spannung verringert. Damit wird die vorgegebene Schwelle S erhöht, und zwar auf eine Schwelle S_{T}, wie in Fig. 4 zu erkennen.

Dies führt zu einem Ausbleiben von Impulsen 15a im Signal 15, was die Überwachungseinrichtung 6 als Phasenausfall und/oder -fehler detektiert. Damit wird die Funktion des Netzwächters 2 in Bezug auf die Überwachung der Phasenleitung L1, L2, L3 am Phasenanschluss 5a, 5b, 5c überprüft.

Dieses Zuschalten des vierten Teilwiderstands 17d wird über eine Steuerleitung 20 veranlasst, die einen von einem zweiten Optokoppler 21 gebildeten Schalter eine elektrische Verbindung über den vierten Teilwiderstand 17d schaltet. Damit verändert sich das Signal 15 dementsprechend, was von der Überwachungseinrichtung 6 erkannt wird und damit die Schwellenschaltung 6a auf Funktion überprüft.

Zudem ist der Netzwächter 2 äußerst flexibel in den Datenbus 11 einzubinden. Die Datenschnittstelle 10 des Netzwächters 2 weist nämlich einen Schalter 22 und zumindest einen Abschlusswiderstand 22 auf, der über den Schalter 21 an den an die Datenschnittstelle 10 angeschlossenen Datenbus 11 zu- und wegschaltbar ist.

Im Allgemeinen wird festgehalten, dass "insbesondere" als "more particularly" ins Englische übersetzt werden kann. Ein Merkmal, dem "insbesondere" vorangestellt ist, ist als fakultatives Merkmal zu betrachten, das weggelassen werden kann, und stellt damit keine Einschränkung, beispielsweise der Ansprüche, dar. Das Gleiche gilt für "vorzugsweise", ins Englische übersetzt als "preferably".

## Patentansprüche

1. Netzwächter für ein Leitungsnetz (3), mit zumindest einer Überwachungseinrichtung (6), mit zumindest einem Phasenanschluss (5a, 5b, 5c), insbesondere Anschlussklemme, für zumindest eine Phasenleitung (L1, L2, L3) des Leitungsnetzes (3), und mit zumindest einem Anschlusspaar (8) für eine elektrische Meldeleitung (9), wobei die Überwachungseinrichtung (6) zur Überwachung der Phasenleitung (L1, L2, L3) am Phasenanschluss (5a, 5b, 5c) auf Phasenausfall und/oder Phasenfehler ausgebildet ist, **dadurch gekennzeichnet, dass**
der Netzwächter (2) eine mit der Überwachungseinrichtung (6) verbundene Datenschnittstelle (10) für einen Datenbus (11) zur drahtlosen und/oder drahtgebundenen Datenverbindung mit einer Überwachungszentrale (12), insbesondere Notbeleuchtungszentrale, aufweist, wobei die Überwachungseinrichtung zur Kommunikation dieses Phasenausfalls und/oder Phasenfehlers über die Datenschnittstelle (10) ausgebildet ist, dass
der Netzwächter (2) zumindest eine elektrische Quelle (13) zur Beaufschlagung des Anschlusspaars (8) mit einem Linienstrom (I_{L}) oder einer Linienspannung (U_{L}) aufweist, und dass
die Überwachungseinrichtung (6) zur Überwachung der elektrischen Meldeleitung (9) über das Anschlusspaar (8) auf Unterbrechung und/oder Veränderung des Linienstroms (I_{L}) oder der Linienspannung (U_{L}) sowie zur Kommunikation dieser Unterbrechung und/oder Veränderung über die Datenschnittstelle (10) ausgebildet ist.

2. Netzwächter nach Anspruch 1, **dadurch gekennzeichnet, dass** das Anschlusspaar (8) zum Anschluss von zumindest einem Schutzschaltgerät (4a, 4b, 4c, 4d, 4e, 4f), insbesondere Leitungsschutzschalter und/oder Fehlerstromschutzschalter, am Leitungsnetz (3) über die Meldeleitung (9) ausgebildet ist.

3. Netzwächter nach Anspruch 1 oder 2, **dadurch gekennzeichnet, dass** die elektrische Quelle (13) eine Konstant-Stromquelle (13a) oder Konstant-Spannungsquelle zur Beaufschlagung des Anschlusspaars (8) mit einem Linienstrom (I_{L}) oder einer Linienspannung (U_{L}) aufweist.

4. Netzwächter nach einem der Ansprüche 1 bis 3, **dadurch gekennzeichnet, dass** die Überwachungseinrichtung (6) eine mit dem Phasenanschluss (5a, 5b, 5c) verbundene Schwellenschaltung (6a) aufweist, die eine am Phasenanschluss (5a, 5b, 5c) anliegende Spannung (U), insbesondere Phasenspannung, mittels einer vorgegebenen Schwelle (S) in ein, insbesondere digitales, Signal (15), insbesondere Binärsignal, konvertiert.

5. Netzwächter nach Anspruch 4, **dadurch gekennzeichnet, dass** das die Schwellenschaltung (6a) einen mit dem Phasenanschluss (5a, 5b, 5c) verbundenen Spannungsteiler (16), der das Verhältnis der Spannungsteilung bestimmende Teilwiderstände (17a, 17b, 17c, 17d) aufweist, und eine an zumindest einen Abgriff (A, B), insbesondere an zwei Abgriffen (A, B), zwischen den Teilwiderständen (17a, 17b, 17c, 17d) des Spannungsteilers (16) angeschossenen, insbesondere als Optokoppler ausgebildete, Schaltstufe (18) zur Erzeugung des Signals (15) aufweist.

6. Netzwächter nach Anspruch 4 oder 5, **dadurch gekennzeichnet, dass** der Netzwächter (2) eine Testschaltung (19) aufweist, die bei Testung des Netzwächters (2) die vorgegebene Schwelle (S) erhöht.

7. Netzwächter nach Anspruch 6, **dadurch gekennzeichnet, dass** die Testschaltung (19) bei einer Testung des Netzwächters (2) das Teilungsverhältnis des Spannungsteilers (16) durch Zu- und/oder Wegschalten von zumindest einem Teilwiderstand (17d) verändert und damit die vorgegebene Schwelle (S) erhöht.

8. Netzwächter nach einem der Ansprüche 4 bis 7, **dadurch gekennzeichnet, dass** die Überwachungseinrichtung (6) das erzeugte Signal (15) zur Erkennung eines Phasenausfalls und/oder -fehlers überwacht.

9. Netzwächter nach einem der Ansprüche 1 bis 8, **dadurch gekennzeichnet, dass** der Netzwächter zumindest einen Nullleiteranschluss (5d), insbesondere eine Anschlussklemme, für zumindest einen Nullleiter (N) des Leitungsnetzes (3) aufweist, wobei die Überwachungseinrichtung (6) zur Überwachung der Phasenleitung (L1, L2, L3) am Phasenanschluss (5a, 5b, 5c) gegen Nullleiter (N) am Nulleiteranschluss (5d) auf Phasenausfall und/oder Phasenfehler ausgebildet ist.

10. Netzwächter nach einem der Ansprüche 1 bis 9, **dadurch gekennzeichnet, dass** die Datenschnittstelle (10) einen Schalter und zumindest einen Abschlusswiderstand aufweist, der über den Schalter an den an die Datenschnittstelle (10) angeschlossenen Datenbus (11) zu- und wegschaltbar ist.

11. Anlage, insbesondere Not- und/oder Sicherheitsbeleuchtungsanlage, mit zumindest einem Netzwächter (2) nach einem der Ansprüche 1 bis 10.

12. Anlage nach Anspruch 11, mit zumindest einem Melder und/oder mit zumindest einem Schutzschaltgerät (4a, 4b, 4c, 4d, 4e, 4f) für ein Leitungsnetz (3), und mit zumindest einer Meldeleitung (9), wobei in die Meldeleitung (9) vom Anschlusspaar (8) des Netzwächters (2) ausgehend der Melder oder das Schutzschaltgerät (4a, 4b, 4c, 4d, 4e, 4f) eingeschliffen ist.

13. Anlage nach Anspruch 12, **dadurch gekennzeichnet, dass** in die Meldeleitung (9) vom Anschlusspaar (8) des Netzwächters (2) ausgehend mehrere Melder und/oder Schutzschaltgeräte (4a, 4b, 4c, 4d, 4e, 4f) in Reihe eingeschliffen sind.

14. Verfahren zur Überwachung zumindest einer Phasenleitung (L1, L2, L3) eines Leitungsnetzes (L) mithilfe eines Netzwächters (2) nach einem der Ansprüche 1 bis 10 oder mithilfe einer Anlage (1) nach einem der Ansprüche 11 bis 13.

15. Verfahren nach Anspruch 14, **dadurch gekennzeichnet, dass** der Netzwächter (2) auf Funktion zur Detektion eines Phasenausfalls und/oder -fehlers getestet wird, indem die Testschaltung (19) die Schwelle (S) für die Schaltstufe (18) der Schwellenschaltung (6a) erhöht.
